# EUROPEAN PATENT APPLICATION

(11) **EP 4 199 666 A1**
(43) Date of publication of application: **21.06.2023**
(21) Application number: 22779469.0
(22) Date of filing: 28.01.2022
(51) Int. Cl.: H05K 7/14, B29C 33/14, B29C 45/14, H05K 1/03

(54) **ELECTRONIC-COMPONENT-ATTACHED RESIN HOUSING AND METHOD FOR MAKING SAME**

(30) Priority: 30.03.2021 JP 2021056483
(71) Applicant: Nissha Co., Ltd., Kyoto-shi, Kyoto 604-8551 (JP)
(72) Inventor: TAKINISHi, Yasuisa, Kyoto-shi, Kyoto 604-8551 (JP); TANIGUCHI, Chuzo, Kyoto-shi, Kyoto 604-8551 (JP); KAWASHIMA, Eiji, Kyoto-shi, Kyoto 604-8551 (JP); NAKAGAWA, Hajime, Kyoto-shi, Kyoto 604-8551 (JP); YOSHIDA, Takenori, Kyoto-shi, Kyoto 604-8551 (JP)
(74) Representative: Grünecker Patent- und Rechtsanwälte PartG mbB
(86) International application number: PCT/JP2022/003323
(87) International publication number: WO 2022/209240

(57) **Abstract**

[Object] To downsize and thin an electrical product, facilitate assembly, and prevent damage and peeling of an electronic component.

[Solution] A resin housing having an electronic component 10 according to the present invention includes a housing 20C made of resin; and an electronic component mounting film 30 that includes: a base film 31 disposed along an inner surface of the housing 20C; a circuit pattern layer 32 formed on at least a surface opposite to a side of the housing 20C of the base film 31; an electronic component 33 connected to the circuit pattern layer 32 and mounted on a surface opposite to the side of the housing 20C of the base film 31; and a reinforcing layer 36 formed on the side of the housing 20C of the base film 31 facing the electronic component 33. The electronic component 33 is integrated with the housing 20C without the electronic component 33 being buried in the housing 20C.

## Description

### Technical Field

The present invention relates to a resin housing having an electronic component and a method for manufacturing the same that can downsize and thin an electrical product, facilitate assembly, and prevent damage and peeling of an electronic component.

### Background Art

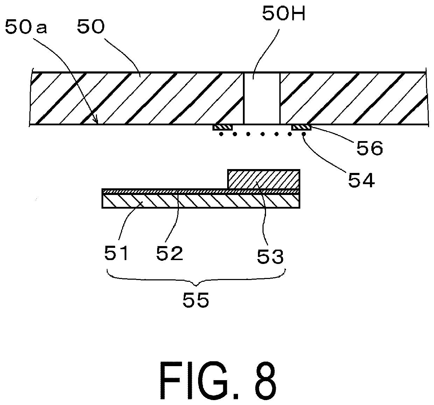

In an electrical product, various electronic components are mounted on a substrate and incorporated into a housing of the electrical product. For example, FIG. 8 is a partially enlarged cross-sectional view illustrating an example of arrangement of a housing and an electronic component of the related art. The electrical product illustrated in FIG. 8 is a smartwatch, and incorporates a speaker 53 as the electronic component. An electronic component mounting substrate 55 is fixed inside a housing 50 made of resin to be away from the housing 50. In the electronic component mounting substrate 55, a circuit pattern layer 52 is formed by patterning a copper foil or the like on a surface on the side of the housing 50 of a substrate 51 made of glass epoxy or the like, and the speaker 53 is electrically connected to the circuit pattern layer 52. Additionally, a speaker hole 50 is provided in a portion overlapping with the speaker 53 of the housing 50. Further, a mesh member 54 for protecting the speaker 53 from dust and dirt is bonded to an inner surface 50a of the housing 50 with an adhesive 56.

However, needs for downsizing and thinning an electrical product always exist, and it is desired to further reduce an accommodation space for accommodating an electronic component. In addition, during assembling the electrical product, a process, such as tightening with screws that fixes an electronic component mounting substrate to an inside of a housing, is complicated. Further, in the case of an electronic component directly acting on an external space of a product (for example, the above-described speaker), it is also desired to bring the electronic component as close as possible to the housing to reduce a distance between the electronic component and the outer surface of the housing to enhance the functional effect.

Therefore, the present applicant has made a new proposal in JP 2020-202467 filed on December 7, 2020.

The application describes a resin housing having an electronic component in which a housing made of resin and an electronic component mounting film as described below are integrated. That is, the electronic component mounting film has the following structure. The electronic component mounting film includes a base film, a circuit pattern layer, and an electronic component. The base film is disposed along an inner surface of the housing. The circuit pattern layer is formed on at least a surface opposite to a side of the housing of the base film. The electronic component is connected to the circuit pattern layer and mounted on a surface opposite to the side of the housing of the base film.

To integrate the housing and the electronic component mounting film, so-called insert molding is used. Specifically, the electronic component mounting film is set in a first mold such that a surface of the electronic component mounting film on which the electronic component is mounted faces the first mold and the electronic component is accommodated in a pocket of the first mold. Next, the first mold and a second mold are clamped to form a cavity between the first mold with the electronic component mounting film and the second mold, and after that finally a molten resin is injected into the cavity to form the housing.

With the configuration, since the electronic component can be firmly fixed by the housing, a substrate is not required separately, and an accommodation space for accommodating the electronic component becomes small. Therefore, the electrical product can be downsized and thinned. In addition, since a complicated process, such as tightening with screws, is not required, assembly is easy. In addition, a distance between the electronic component and an outer surface of the housing can be reduced to enhance a functional effect of the electronic component directly acting on an external space of the electrical product.

### Summary of Invention

### Technical Problem

However, when insert molding of the electronic component mounting film is performed in a state where the electronic component is accommodated in the pocket of the first mold as described above, a back surface side of the electronic component may be damaged by resin pressure of the molten resin, and the resin may flow into the electronic component.

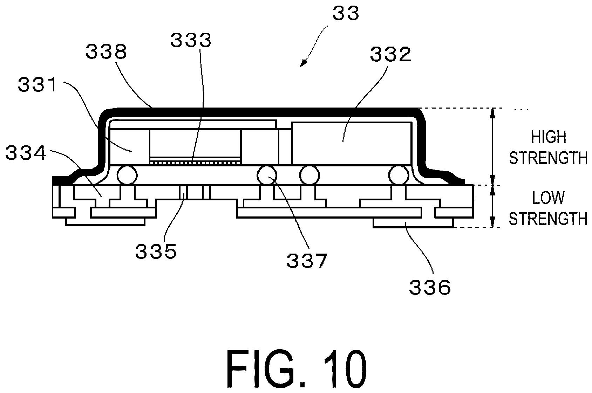

For example, as illustrated in FIG. 10, when a plurality of parts are mounted on a substrate of an electronic component 33 and the plurality of parts are covered with a cover 338 made of aluminum or the like, a front surface side of the electronic component 33 is protected by the cover 338, but the back surface side of the electronic component 33 is not protected by the cover 338, and therefore the strength of the back surface side is low. In FIG. 10, reference numeral 331 denotes a MEMS chip, reference numeral 332 denotes an IC chip, reference numeral 333 denotes a vibration film, reference numeral 334 denotes a ceramic substrate, reference numeral 335 denotes a sound hole, reference numeral 336 denotes a terminal electrode, and reference numeral 337 denotes a solder ball.

Since a portion of the base film of the electronic component mounting film in which the electronic component is accommodated in the pocket of a mold is not supported by a cavity inner wall, a surface on which the electronic component is mounted may be waved by heat pressure of the molten resin, and causes deformation, such as distortion or unevenness. As a result, the electronic component may be peeled off from the base film or the circuit pattern layer.

An object of the present invention is to solve the above-described problems, downsize and thin an electrical product, facilitate assembly, and prevent damage and peeling of an electronic component.

### Solution to Problem

Some aspects will be described below as means to solve the problems. These aspects can be combined randomly as necessary.

A resin housing having an electronic component of the present invention includes a housing and an electronic component mounting film. The housing is made of resin. The electronic component mounting film includes a base film, a circuit pattern layer, an electronic component, and a reinforcing layer. The base film is disposed along an inner surface of the housing. The circuit pattern layer is formed on at least a surface opposite to a side of the housing of the base film. The electronic component is connected to the circuit pattern layer and mounted on a surface opposite to the side of the housing of the base film. The reinforcing layer is formed on the side of the housing of the base film facing the electronic component. The electronic component is integrated with the housing without the electronic component being buried in the housing.

In the resin housing having the electronic component having such a configuration, the electronic component mounting film is integrated along the inner surface of the housing. Accordingly, since the electronic component can be firmly fixed by the housing, a substrate is not required separately, and an accommodation space for accommodating the electronic component becomes small. Therefore, the electrical product can be downsized and thinned. In addition, since a complicated process, such as tightening with screws, is not required, assembly is easy. In addition, a distance between the electronic component and an outer surface of the housing can be reduced to enhance a functional effect of the electronic component directly acting on an external space of the electrical product.

The electronic component of the resin housing having the electronic component is integrated without being buried in the housing. As a result, during integral molding of the housing with the electronic component mounting film, the electronic component does not receive resin pressure of the molten resin from a side surface direction, and it is possible to prevent position displacement and damage of the electronic component. In addition, since the circuit pattern layer provided on the base film of the electronic component mounting film is not bent along the side surface of the electronic component, disconnection of the circuit pattern layer can be suppressed. In addition, repair of the electronic component is easy.

Furthermore, since the reinforcing layer formed so as to face the electronic component on the side of the housing of the base film is provided, in the resin housing having the electronic component, the reinforcing layer overlaps with the vicinity of the electronic component of the electronic component mounting film. As a result, damage of the back surface side of the electronic component by resin pressure of the molten resin during integral molding of the housing with the electronic component mounting film can be prevented.

In addition, the presence of the reinforcing layer can avoid the surface on which the electronic component is mounted of the base film to be waved by heat pressure of the molten resin, and cause deformation, such as distortion or unevenness, and prevent the electronic component from being peeled off from the base film or the circuit pattern layer.

As one aspect, the reinforcing layer is preferably formed of a reinforcing plate bonded to the base film. In particular, a material of the reinforcing plate is preferably any one of a polyimide resin, a polycarbonate resin, a polyethylene terephthalate resin, and a metal.

According to the configuration, since strength of the reinforcing layer is increased, an effect of preventing damage and peeling of the electronic component can be improved.

As one aspect, the reinforcing layer is preferably formed of a cured coating film of a UV-curable resin or a thermosetting resin.

According to the configuration as well, since the strength of the reinforcing layer is increased, the effect of preventing damage and peeling of the electronic component can be obtained. Since it is a coating film, forming and patterning the reinforcing layer are facilitated.

As one aspect, the reinforcing layer preferably includes a mesh member inside the layer.

According to the configuration, the mesh member can also be used as the reinforcing layer without separately providing a mesh member for providing an electrical function, such as an electromagnetic wave shield. In addition, the mesh member can exert as a core material to increase the strength of the reinforcing layer.

As one aspect, an opening penetrating from the housing to the base film is preferably provided. The mesh member is preferably present in the reinforcing layer so as to at least overlap with a through-hole constituting the opening in the reinforcing layer.

According to the configuration, the mesh member can also be used as the reinforcing layer without separately providing a mesh member for protecting an opening, such as a speaker hole or a microphone hole. In this case as well, the mesh member can exert as a core material to increase the strength of the reinforcing layer.

As one aspect, a formation region of the reinforcing layer preferably internally includes an entire mounting region of the electronic component.

According to the configuration, since the formation region of the reinforcing layer is wide, the electronic component can be prevented from being damaged or peeled completely in any portion of the electronic component.

As one aspect, a formation region of the reinforcing layer is preferably a part of a mounting region of the electronic component.

According to the configuration, only a portion of the electronic component having a low pressure resistance is reinforced with pinpoint precision, and the electronic component can be prevented from being damaged or peeled. In this case, since the formation area of the reinforcing layer in plan view can be reduced, that is, the side surface area of the reinforcing layer can be reduced, it is also possible to prevent position displacement of the reinforcing layer due to the resin pressure of the molten resin and poor filling of a molten resin 300. In addition, since an amount of material used for the reinforcing layer can be reduced, there is also a cost advantage.

A method for manufacturing a resin housing having an electronic component of the present invention includes: preparing the above-described electronic component mounting film; setting the electronic component mounting film in a first mold; clamping the first mold and a second mold to form a cavity; and injecting a molten resin into the cavity to mold a housing and integrating the electronic component mounting film along an inner surface of the housing. In the electronic component mounting film, during setting in the first mold, the surface on which the electronic component is mounted faces the first mold. The first mold has a pocket. The pocket of the first mold accommodates the electronic component when the electronic component mounting film is set. The cavity is formed between the first mold with the electronic component mounting film and the second mold.

In the method for manufacturing the resin housing having the electronic component having such a configuration, the electronic component mounting film is integrated along the inner surface of the housing. Accordingly, since the electronic component can be firmly fixed by the housing, a substrate is not required separately, and an accommodation space for accommodating the electronic component becomes small. Therefore, the electrical product can be downsized and thinned. In addition, since a complicated process, such as tightening with screws, is not required, assembly is easy. In addition, a distance between the electronic component and an outer surface of the housing can be reduced to enhance an effect of the electronic component directly acting on an external space of the electrical product.

In the method for manufacturing the resin housing having the electronic component, integral molding is performed in a state where the electronic component is accommodated in the pocket of the first mold. As a result, the electronic component does not receive the resin pressure of the molten resin from the side surface direction, and it is possible to prevent position displacement and damage of the electronic component. In addition, repair of the electronic component is easy.

As one aspect, a formation region of the reinforcing layer preferably includes an entire formation region of the pocket.

According to the configuration, the reinforcing layer is supported by a cavity inner wall constituting a periphery of the pocket, and flatness of the entire pocket region of the base film against the resin pressure of the molten resin is easily maintained. Therefore, it is possible to improve the effect of preventing damage or peeling of the electronic component.

### Advantageous Effects of Invention

The resin housing having the electronic component of the present invention can downsize and thin the electrical product, facilitate assembly, and prevent damage and peeling of the electronic component.

### Brief Description of Drawings

FIG. 1 is a perspective view illustrating an example of a smartwatch to which a resin housing having an electronic component according to a first embodiment is applied.
FIG. 2 is an exploded perspective view of the resin housing having the electronic component according to the first embodiment.
FIG. 3 is a partially enlarged cross-sectional view of the resin housing having the electronic component according to the first embodiment (cross-section taken along the line A-A in FIG. 1).
FIG. 4 is a schematic diagram illustrating an example of a reinforcing layer of the resin housing having the electronic component according to the first embodiment.
FIG. 5 is a partially enlarged cross-sectional view illustrating an example of a state before the electronic component mounting film is set in a first mold.
FIG. 6 is a partially enlarged cross-sectional view illustrating an example of a state after the electronic component mounting film is set in the first mold.
FIG. 7 is a partially enlarged cross-sectional view illustrating an example of a state in which molten resin is injected into a cavity.
FIG. 8 is a partially enlarged cross-sectional view illustrating an example of arrangement of a housing and an electronic component according to the related art.
FIG. 9 is a partially enlarged cross-sectional view illustrating a case where there is no pocket for accommodating the electronic component.
FIG. 10 is a schematic diagram illustrating an example of an internal structure of the electronic component.
FIG. 11 is a partially enlarged cross-sectional view of the resin housing having the electronic component according to a second embodiment.
FIG. 12 is a partially enlarged cross-sectional view of the resin housing having the electronic component according to a third embodiment.
FIG. 13 is a schematic diagram illustrating an example of a stacked state of the reinforcing layer and a mesh member of the resin housing having the electronic component according to the third embodiment.
FIG. 14 is a partially enlarged cross-sectional view of the resin housing having the electronic component according to a fourth embodiment.
FIG. 15 is a partially enlarged cross-sectional view of the resin housing having the electronic component according to a modified example.
FIG. 16 is a partially enlarged cross-sectional view of anther resin housing having the electronic component according to a modified example.

### Description of Embodiments

### First Embodiment

A resin housing having an electronic component and a method for manufacturing the same according to the first embodiment of the present invention will be described below with reference to the drawings.

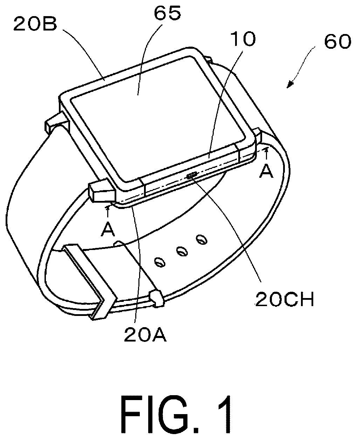

FIG. 1 is a perspective view illustrating an example of a smartwatch to which the resin housing having the electronic component according to the first embodiment of the present invention is mounted. Needs for downsizing and thinning always exist for a smartwatch 60 equipped with a large screen illustrated in FIG. 1, and the smartwatch 60 is suitable for an electrical product to which the present invention is applied. Although the smartwatch 60 is an example of the electrical product to which the present invention is applied in the present embodiment, the electrical product to which the present invention is applied is not limited to the smartwatch 60.

A body of the smartwatch 60 includes a housing disposed so as to cover a surface opposite to a display surface of a display panel 65 and side surfaces thereof. In the example illustrated in FIG. 1, three housings of a housing 20A constituting a bottom surface portion, a housing 20B constituting a C-shaped frame, and a resin housing having an electronic component 10, which is provided between both ends of the housing 20B to constitute a frame and includes a speaker, are combined. Among them, the resin housing having the electronic component 10 provided with the speaker is the resin housing having the electronic component according to the first embodiment of the present invention.

### (1) Outline of Resin Housing Having Electronic Component 10

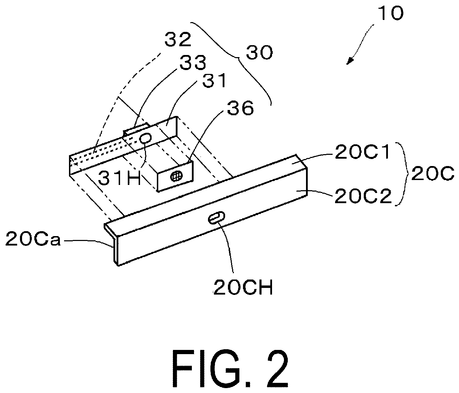

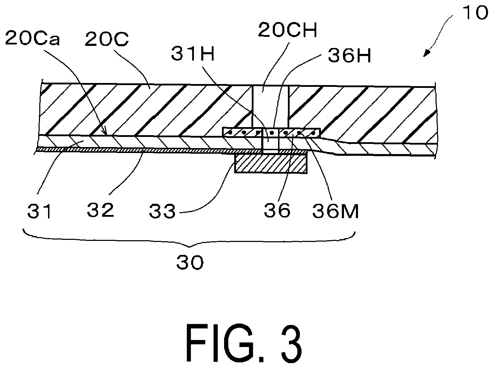

The resin housing having the electronic component 10 is molded by insert molding. As illustrated in FIGS. 2 and 3, the resin housing having the electronic component 10 is a component of the smartwatch 60 in which a housing 20C made of thermoplastic resin and an electronic component mounting film 30 are completely integrated.

### (2) Housing 20C

The housing 20C is a molded article made of resin having an L-shaped cross section and including an elongated upper surface portion 20C1 and an elongated side surface portion 20C2. The side surface portion 20C2 has a speaker hole 20CH penetrating near the center in the longitudinal direction.

As the material of the housing 20C, a general-purpose thermoplastic resin, such as a polystyrene-based resin, a polyolefin-based resin, an ABS resin, or an AS resin, is preferably used. Besides, a polycarbonate-based resin, a polyacetal resin, an acrylic-based resin, a polybutylene terephthalate resin, an engineering resin (for example, a polysulfone resin, a polyphenylene sulfide-based resin, a polyphenylene oxide-based resin, and a polyarylate-based resin), a polyamide-based resin, or a urethane-based, polyester-based, or styrene-based elastomer can be used as the material of a molded body 21. Furthermore, natural rubber and synthetic rubber can be used as the material of the molded body 21. A reinforcing material, such as glass fiber or inorganic filler, can be added to the housing 20C.

The housing 20C may be colored, or the outer surface of the housing 20C may be covered with a decorative layer. Alternatively, both of them may be employed.

### (3) Electronic Component Mounting Film 30

FIGS. 2 and 3 illustrate the structure of the electronic component mounting film 30.

The electronic component mounting film 30 includes a base film 31, a circuit pattern layer 32, a speaker 33 (an example of the electronic component), and a reinforcing layer 36.

### (3-1) Base Film 31

As illustrated in FIG. 3, the base film 31 is disposed on a side of an inner surface 20Ca along the side surface portion 20C2 of the housing 20C.

Although the speaker hole 20CH is provided in the side surface portion 20C2 of the housing 20C on which the base film 31 is disposed, a mesh member 36M is interposed between the base film 31 and the speaker hole 20CH of the housing 20C, and thus the base film 31 is not exposed from the speaker hole 20CH. Therefore, the base film 31 may be transparent or opaque.

The material of the base film 31 is selected from, for example, a resin film made of a polyester resin, a polyethylene terephthalate (PET) resin, an acrylic resin, a polycarbonate resin, a polybutylene terephthalate (PBT) resin, a triacetyl cellulose resin, a polyimide resin, a liquid crystal polymer, an urethane resin, a silicone resin, a styrene resin, or an ABS resin, a multilayer film made of an acrylic resin and an ABS resin, or a multilayer film made of an acrylic resin and a polycarbonate resin. The thickness of the base film 31 is selected from a range, for example, from 15 µm to 400 µm. Since it has a thickness likely to be flexible, the position is not stable simply by disposing it inside the housing 20C in this state. By integrating the electronic component mounting film 30 with the housing 20C, the electronic component 33 can be firmly fixed.

### (3-2) Circuit Pattern Layer 32

As illustrated in FIG. 3, the circuit pattern layer 32 is formed on a surface opposite to the side of the housing 20C of the base film 31.

The circuit pattern layer 32 is formed by etching a copper foil or formed by printing conductive ink by thick film printing. The thickness of the circuit pattern layer 32 is, for example, from 1 µm to 30 µm. The conductive ink contains a conductive filler and a binder. As the conductive filler, for example, powder of a conductive material or conductive powder obtained by plating surfaces of non-conductive particles with a metal can be used. Examples of the conductive material include gold, silver, copper, aluminum, nickel, carbon, and graphite. Example of the conductive powder plated with the metal includes conductive powder obtained by plating surfaces of urethane particles or silica particles with copper, nickel, or silver. A thermoplastic resin, such as a polyester-based resin, an acrylic-based resin, a vinyl chloride-vinyl acetate copolymer resin, a vinyl chloride-vinyl acetate-maleic acid copolymer resin, or a thermoplastic urethane resin blended with a tackifier, which develops adhesiveness by heat of, for example, a rosin-based resin, a rosin ester-based resin, or a petroleum resin, can be used as the binder. A solvent used in the ink is, for example, one suitable for thick film printing. The thick film printing includes, for example, screen printing and inkjet printing. As the binder, in addition to the thermoplastic resin, for example, use of an epoxy-based, urethane-based, or acrylic-based thermosetting resin or an ultraviolet-curable resin is possible. Even when a thermosetting resin or an ultraviolet-curable resin is used as the binder, a proportion of a conductive filler dispersed in the circuit pattern layer 32 is large, and thus strength like the strength of the reinforcing layer 36 cannot be obtained. Since the circuit pattern layer 32 the circuit pattern layer 32 is formed of the materials and the thickness as described above, disconnection is likely to occur when the circuit pattern layer 32 is bent.

### (3-3) Speaker 33

As illustrated in FIG. 3, the speaker 33 is connected to the circuit pattern layer 32 and mounted on the surface opposite to the side of the housing 20C of the base film 31.

A sound wave generation direction of the speaker 33 is the side of the housing 20C. Therefore, the base film 31 is provided with a through-hole 31H so as to easily transmit a sound wave from the speaker 33 at the back.

As the speaker 33, a small and thin speaker mounted on a mobile device or the like is used. The speaker 33 is mounted by soldering, application and curing of a conductive adhesive paste, or pressure bonding with anisotropic conductive paste (not illustrated).

### (3-4) Reinforcing Layer 36

As illustrated in FIG. 3, the reinforcing layer 36 is formed on the side of the housing 20C of the base film 31 facing the electronic component 33. In the present embodiment, a formation region of the reinforcing layer 36 internally includes the entire mounting region of the speaker 33.

In the present embodiment, the reinforcing layer 36 is formed of a reinforcing plate bonded to the base film 31. As the material of the reinforcing plate, a polyimide resin, a polycarbonate resin, a polyethylene terephthalate resin, an epoxy resin, a glass epoxy resin, an ABS resin, a PC/ABS alloy, a metal, or the like can be used. Among them, from the viewpoint of strength, a polyimide resin, a polycarbonate resin, a polyethylene terephthalate resin, and a metal are particularly preferable. Furthermore, a polycarbonate resin is more preferable in that the reinforcing layer 36 can be brought into close contact with and integrated with the housing 20C by heat of the molten resin 300 while maintaining the strength of the reinforcing layer 36.

As means for forming the reinforcing plate on the side of the housing 20C of the base film 31, an adhesive layer (not illustrated) is used.

An adhesive or an adhesive film can be used as the adhesive layer. As the adhesive, an acrylic resin, a urethane resin, a polyester resin, a polyamide resin, an ethylene butyl alcohol resin, an ethylene vinyl acetate copolymer, a vinyl chloride-vinyl acetate copolymer, or the like can be used. As the method for forming the adhesive layer or the like, a typical printing method, such as an offset printing method, a gravure printing method, and a screen printing method, or a coating method, such as a gravure coating method, a roll coating method, or a comma coating method, can be used. Further, as the adhesive layer, an adhesive film can be laminated on the side of the housing 20C of the base film 31 for use. As the adhesive film, for example, an unstretched polypropylene film can be used and laminated by a dry lamination method.

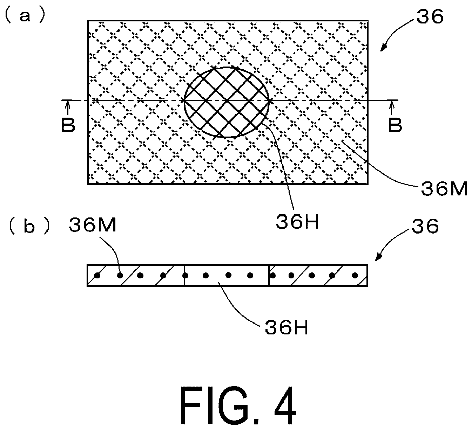

A resin housing having an electronic component 1C of the present embodiment has an opening penetrating a laminated body from the housing 20C to the base film 31 to dispose the speaker 33 on the backmost surface of the electronic component mounting film 30. Therefore, to provide this opening, as well as the speaker hole 20CH of the housing 20C and the through-hole 31H of a base film 21, a through-hole 36H is provided in the reinforcing layer 36 (see FIGS. 3 and 4).

The plate thickness of the reinforcing plate is preferably 20 µm or greater and a half of the thickness of the housing 20C or less. When the plate thickness of the reinforcing plate exceeds a half of the housing 20C, the side surface area of the reinforcing plate that receives the resin pressure of the molten resin 300 is large, thus causing position displacement of the reinforcing plate and poor filling of the molten resin 300. When the film thickness of the plate thickness of the reinforcing plate is less than 20 µm, the reinforcing plate cannot have sufficient strength, and the molten resin 300 enters into a structural member of the speaker 33 via the base film 31 due to the resin pressure of the molten resin 300.

### (3-5) Mesh Member 36M

In the present embodiment, the mesh member 36M is a sheet included inside the layer of the reinforcing layer 36 (see FIGS. 3 and 4). In FIG. 4, FIG. 4(a) is plan view of the reinforcing layer 36 including the mesh member 36M, and FIG. 4(b) is a cross-sectional view thereof (a cross section taken along the line B-B in FIG. 4(a)). The mesh member 36M is present in the reinforcing layer 36 so as to at least overlap with the through-hole 36H of the reinforcing layer 36. As illustrated in FIG. 3, it is preferable from the viewpoint of appearance that the mesh member 36M is disposed so as to cover the speaker hole 20CH of the housing 20C.

The mesh member 36M suppresses entrance of dust, dirt, or the like to the speaker 33 of the smartwatch 60 through a speaker hole 2CH and the through-holes 31H, 36H.

As examples of the material of the mesh member 36M, in addition to metal, such as nickel, copper, iron, aluminum, and titanium, and an alloy thereof (for example, monel, steel, yellow brass, red brass, phosphor bronze, Hastelloy (trademark of Haynes International in the United States of America), Inconel (trademark of Specialty Metals), such as nichrome), a resin, such as an acrylic resin, nylon (trademark of Du Pont), polyester, polypropylene, polyethylene, and Teflon (registered trademark of Du Pont) can be used. The mesh member 36M may be a woven fabric. A shape and an array of holes of the mesh member 36M are not limited as long as the holes do not unnecessarily block sound waves. For example, holes having a polygonal shape, such as a plurality of quadrangular shapes, and circular shapes may be arrayed, or the holes may be a plurality of slit-like holes. Further, water repellent treatment may be provided for waterproofing.

### (4) Manufacturing Resin Housing Having Electronic Component 10

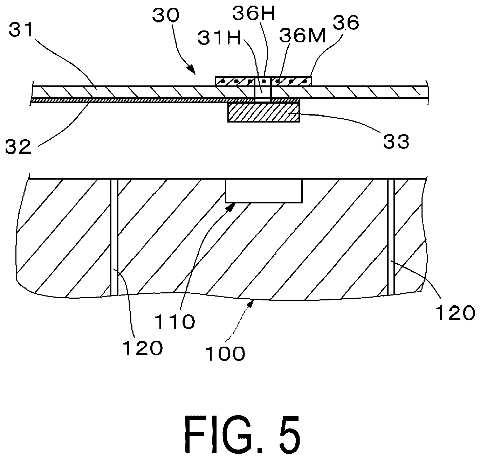

An example of the method for manufacturing the resin housing having the electronic component 10 will be described with reference to FIGS. 5 to 7.

First, as illustrated in FIG. 5, the electronic component mounting film 30 is inserted between a first mold 100 and a second mold 200 (not illustrated) for molding the housing 20C. At this time, the surface on which the speaker 33 is mounted of the electronic component mounting film 30 faces the first mold 100.

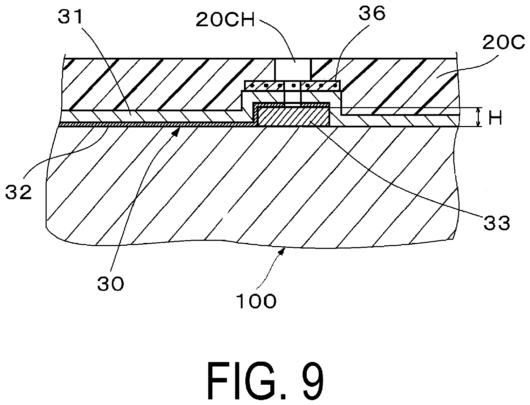

The first mold 100 is provided with a pocket 110 for accommodating the speaker 33. Thus, it is possible to avoid the speaker 33 to being buried in the housing 20C after molding. In a case where the first mold 100 has a smooth surface without the pocket 110, the surface opposite to the side of the base film 31 of the speaker 33 is formed to be flush with its periphery (see FIG. 9). That is, the speaker 33 is buried in the housing 20C. In this case, the speaker 33 possibly receives the resin pressure of the molten resin 300 from the side surface direction and causes position displacement and damage of the speaker 33. In addition, since the base film 31 and the circuit pattern layer 32 of the electronic component mounting film 30 are bent by a thickness H of the speaker 33, the circuit pattern layer 32 may be disconnected. Further, when the speaker 33 is buried in the housing 20C, the speaker 33 cannot be repaired.

The size of the pocket 110 of the first mold 100 is formed to be larger than the size of the speaker 33 accommodated in the pocket 110. This is because when the dimensions of the pocket 110 are the same as that of the speaker 33, it is difficult to fit the speaker 33 into the pocket 110 and it is difficult to take out the speaker 33 from the pocket 110 after molding. When the pocket 110 is forcibly fitted or forcibly taken out while the dimensions of the pocket 110 are the same size as that of the speaker 33, the speaker 33 is possibly damaged. Further, one of the reasons why the size of the pocket 110 is made larger is that there is a slight mounting error occurs in the horizontal direction and the vertical direction in mounting the speaker 33 in the resin housing having the electronic component 10.

A plurality of suction holes 120 are provided on a surface facing the electronic component mounting film 30 of the first mold 100. Thus, the electronic component mounting film 30 can be sucked and fixed to the first mold 100 by vacuum suction.

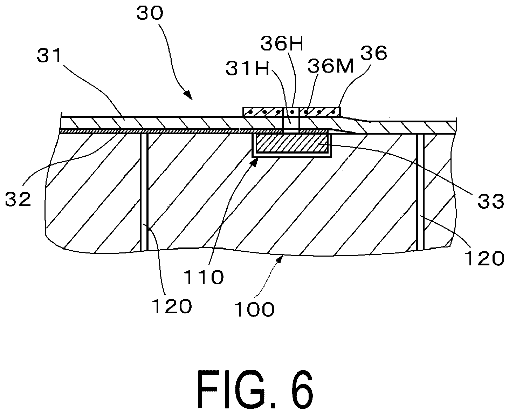

Thereafter, as illustrated in FIG. 6, the electronic component mounting film 30 is set in the first mold 100. At this time, the speaker 33 is accommodated in the pocket 110 of the first mold 100.

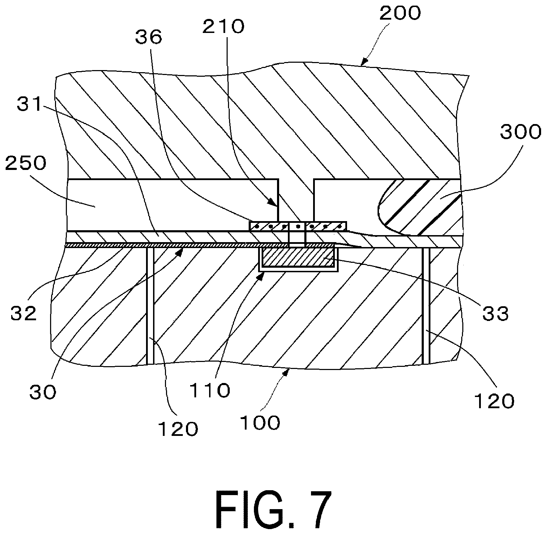

FIG. 7 illustrates a state in which the first mold 100 and the second mold 200 are closed.

A cavity 250 is formed between the first mold 100, the electronic component mounting film 30, and the second mold 200. The second mold 200 is provided with a pin 210 that protrudes to face a mesh member 36a of the electronic component mounting film 30. The pin 210 is for forming the speaker hole 20CH of a molded article 20C.

In a state where the speaker 33 is covered with the reinforcing layer 36, the molten resin 300 is injected into the cavity 250 (see FIG. 7) to form the housing 20C. Then, when the molten resin 300 is cooled and solidified, the housing 20C molded by solidifying the molten resin 300 and the electronic component mounting film 30 are completely integrated. The material of the molten resin 300 is the same as the material of the housing 20C described above, and is injected in a molten state at a temperature of the melting point or higher.

Next, the first mold 100 and the second mold 200 are opened. For example, the resin housing having the electronic component 10 is removed from the second mold 200 using an ejector pin (not illustrated) protruding from the second mold 200, and is held and taken out by an approaching extraction robot (not illustrated).

### (6) Modified Examples

### (6-1) Modified Example 1

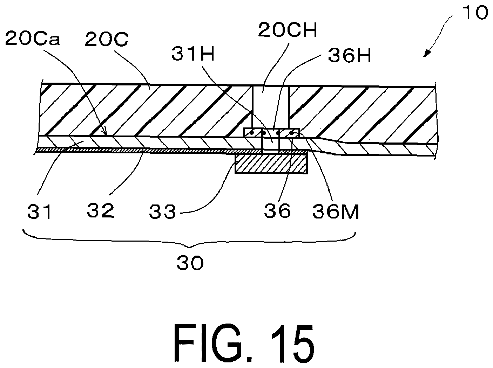

In the first embodiment, the case where the formation region of the reinforcing layer 36 internally includes the entire mounting region of the speaker 33 has been illustrated and described, but the formation region of the reinforcing layer 36 is not limited thereto. For example, as illustrated in FIG. 15, the formation region of the reinforcing layer 36 may be a part of the mounting region of the speaker 33.

### (6-2) Modified Example 2

In the first embodiment, the case where the circuit pattern layer 32 is formed only on the surface opposite to the side of the housing 20C of the base film 31 has been illustrated and described. However, the method for forming the circuit pattern layer 32 is not limited thereto. For example, the circuit pattern layers 32 may be formed on both surfaces of the base film 31.

### (6-3) Modified Example 3

In the first embodiment, the case where the circuit pattern layer 32 is formed only on the surface opposite to the side of the housing 20C of the base film 31 has been illustrated and described. However, the method for forming the circuit pattern layer 32 is not limited thereto. For example, the circuit pattern layers 32 may be formed on both surfaces of the base film 31.

Note that the circuit pattern layer 32 formed on the surface opposite to the side of the housing 20C of the base film 31 and electrically connected to the speaker 33 may be drawn to the surface on the side of the housing 20C of the base film 31 via a through hole. At this time, on the surface opposite to the side of the housing 20C of the base film 31, the circuit pattern layer 32 may be configured by only a land for mounting the speaker 33 in the shortest case.

### (6-4) Modified Example 4

In the first embodiment, the case where the surface on the side of the housing 20C of the base film 31 of the electronic component mounting film 30 is directly integrated with the housing 20C has been illustrated and described, but the integration of the electronic component mounting film 30 with the housing 20C is not limited thereto. For example, an adhesive layer may be interposed between the electronic component mounting film 30 and the housing 20C.

An adhesive or an adhesive film can be used as the adhesive layer. The material of the adhesive and the method for forming the adhesive layer or the like are similar to those used for bonding the reinforcing plate.

### (6-5) Modified Example 5

In the first embodiment, the case where the circuit pattern layer 32 formed on the surface opposite to the side of the housing 20C of the base film 31 is exposed in the electronic component mounting film 30 is illustrated and described, but the present invention is not limited thereto. For example, the circuit pattern layer 32 formed on the surface opposite to the side of the housing 20C of the base film 31 may be covered with a cover film except for at least a region necessary for mounting the speaker 33. The region necessary for mounting the speaker 33 may be the speaker 33 and the periphery of the speaker 33, or may be only the connection region with the speaker 33. In addition to the region necessary for mounting the speaker 33, for example, another terminal portion can also be exposed. In any case, since the cover film covers excluding a region necessary for mounting the speaker 33, the cover film cannot be substituted for the reinforcing layer 36 of the present invention.

In Modified Example 5, the cover film is adhered to cover the circuit pattern layer 32 with an adhesive such that the circuit pattern layer 32 is not exposed to the outside except for a part of the circuit pattern layer 32. The cover film is made of polycarbonate, polyethylene terephthalate (PET), an acrylic film, or the like.

When the circuit pattern layers 32 are formed on both surfaces of the base film 31, the circuit pattern layer 32 on the side of the housing 20C may be covered with a cover film. Alternatively, both of the circuit pattern layers 32 formed on both surfaces may be covered with cover films.

When the circuit pattern layer 32 on the side of the housing 20C is covered with the cover film, it is preferable to provide the adhesive layer used to bond the reinforcing plate for firm integration with the housing 20C.

### (6-6) Modified Example 6

In the first embodiment, the case where the housing 20C and the electronic component mounting film 30 are completely integrated has been described as an example, but the present invention is not limited thereto. For example, when the speaker 33 of the electronic component mounting film 30 is fixed at an accurate position with respect to the speaker hole 20CH of the housing 20C, a part of the electronic component mounting film 30 need not be integrated with the housing 20C.

As an example, a part of the electronic component mounting film 30 may include the circuit pattern layer 32 and be away from the inner surface 20Ca of the housing 20C to be free. That is, a part of the electronic component mounting film 30 can function as Flexible Printed Circuits (FPCs). In this case, at manufacturing the resin housing having the electronic component 10, a portion of the electronic component mounting film 30 that is free from the housing 20C is accommodated in the first mold 100.

### (6-7) Modified Example 7

In the first embodiment, the case where the speaker 33 is mounted as the electronic component on the resin housing having the electronic component 10 has been described, but the electronic component to be mounted is not limited thereto. For example, a microphone may be mounted as the electronic component. In this case, the speaker hole 20CH of the housing 20C serves as a microphone hole.

### (6-8) Modified Example 8

In the first embodiment, the electrical product incorporating the resin housing having the electronic component 10 is the smartwatch 60, but the electrical product to which the present invention is applied is not limited to the smartwatch 60. For example, it may be any various home electrical products including smart glasses, a notebook computer, a tablet terminal, a smartphone, and a game machine, or an automobile interior product. Therefore, the shape of the housing 20C is not limited to the shape of the first embodiment.

### (6-9) Modified Example 9

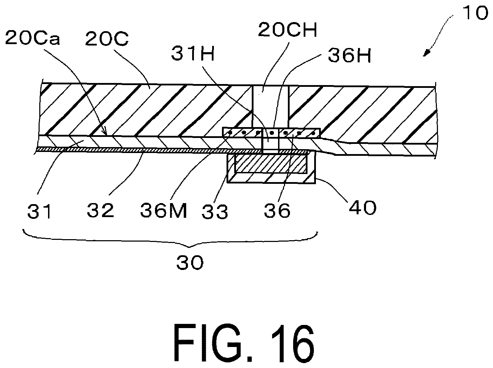

In the first embodiment, the case in which only the speaker 33 is accommodated in the pocket 110 of the first mold 100 in the manufacturing step of integrating the housing 20C and the electronic component mounting film 30 has been described, but the present invention is not limited thereto. For example, as described in the above-described JP 2020-202467, the speaker 33 may be accommodated in the pocket 110 so as to fill the pocket 110 of the first mold 100 together with an impact absorbing layer 40 (see FIG. 16).

The impact absorbing layer 40 itself changes the shape such that the circuit pattern layer 32 of the electronic component mounting film 30 can maintain a non-bending state around the portion where the electronic component is mounted during clamping the first mold 100 and the second mold 200.

As the material of the impact absorbing layer 40, for example, 1) a material having excellent heat resistance and cushioning property and 2) a hot melt material can be used.

### Second Embodiment

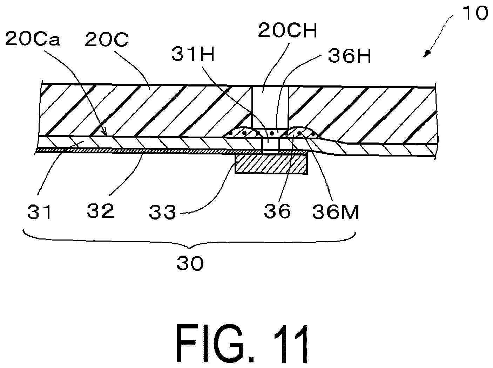

Next, the resin housing having the electronic component according to the second embodiment of the present invention will be described with reference to FIG. 11. The second embodiment is different from the first embodiment in that the reinforcing layer 36 is formed of not the reinforcing plate but a cured coating film.

In the second embodiment, a UV curable resin or a thermosetting resin can be used as the material of the cured coating film constituting the reinforcing layer 36. Examples of such a resin can include a urethane acrylate-based resin, an epoxy acrylate-based resin, a polyester acrylate-based resin, an epoxy-based resin, a urethane-based resin, an acrylic-based resin, a resin obtained by adding an additive, such as isocyanate, to these resins, and the like.

In addition to a potting method, examples of the coating method include a typical printing method, such as a dispenser method, a gravure printing method, a screen printing method, a pad printing, an inkjet method, and an offset printing method, and a gravure coating method, a roll coating method, and a die coating method. The film thickness of the cured coating film is preferably 50 µm or greater and a half of the thickness of the housing 20C or less. When the film thickness of the cured coating film exceeds a half of the housing 20C, the side surface area of the cured coating film that receives the resin pressure of the molten resin 300 is large, thus causing position displacement of the reinforcing plate and poor filling of the molten resin 300. When the film thickness of the cured coating film is less than 50 µm, the cured coating film cannot have sufficient strength, and the molten resin 300 enters into the structural member of the speaker 33 via the base film 31 due to the resin pressure of the molten resin 300.

To include the mesh member 36M in the layer of the reinforcing layer 36 formed of the cured coating film, for example, there is a method in which the mesh member 36M is disposed and then covered with the coating film to fill pores of the mesh member 36M with a coating film material and then the coating film material is cured. Further, there is also a method in which the mesh member 36M is sunk from above the formed coating film into the coating film, and then it is cured. The mesh member 36M may be at any of a depth position near the surface in the layer, an intermediate depth position, or a depth position near the bottom.

Since the description of the other points overlaps with that of the first embodiment, the description thereof will be omitted. In addition, each modified example described in the first embodiment can also be applied to the second embodiment.

### Third Embodiment

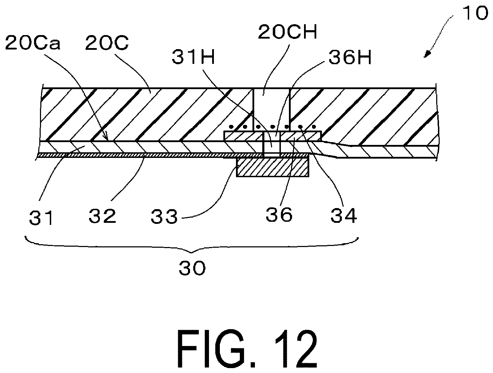

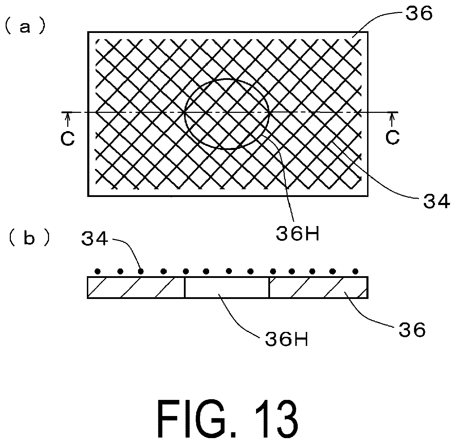

Next, the resin housing having the electronic component according to the third embodiment of the present invention will be described with reference to FIGS. 12 and 13. The resin housing having the electronic component according to the second embodiment is different from the resin housing having the electronic component according to the first embodiment in that the reinforcing layer 36 does not include the mesh member 36M in the layer and a mesh member 34 is stacked on the reinforcing layer 36. In FIG. 13, FIG. 13(a) is plan view of a laminated body of the reinforcing layer 36 and the mesh member 34, and FIG. 13(b) is a cross-sectional view thereof (a cross section taken along the line C-C in FIG. 13(a)).

In the third embodiment, as the mesh member 34 stacked on the reinforcing layer 36, the one similar to the mesh member 36M used in the first embodiment can be used.

An adhesive layer can be used to fix the mesh member 34. The material of the adhesive and the method for forming the adhesive layer or the like are similar to those used for bonding the reinforcing plate.

In the example illustrated in FIG. 12, the mesh member 34 is stacked on a side of a housing 12C of the reinforcing layer 36, but the mesh member 34 may be stacked between the reinforcing layer 36 and the base film 31.

Since the description of the other points overlaps with that of the first embodiment, the description thereof will be omitted. In addition, each modified example described in the first embodiment can also be applied to the third embodiment.

### Fourth Embodiment

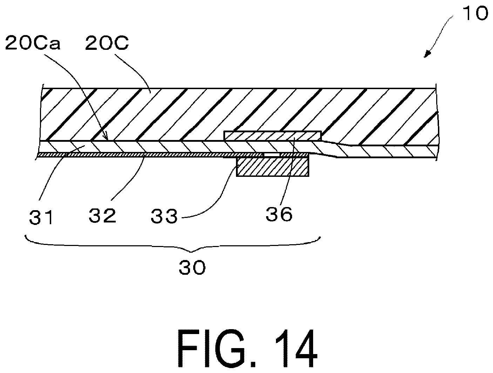

Next, a method for manufacturing the resin housing having the electronic component according to the fourth embodiment of the present invention will be described with reference to FIG. 14. The fourth embodiment is different from the first embodiment in that the fourth embodiment does not have an opening that penetrates the laminated body from the housing 20C to the base film 31 and not include the mesh member 36M that protects from dust and dirt entering from the opening.

For example, when an electronic component other than the speaker 33 or the microphone is mounted, a path for transmitting sound waves is not necessary. For example, when the electronic component is an IR sensor or an LED, the surfaces may be completely covered with the light-transmissive housing 20C.

Since the description of the other points overlaps with that of the first embodiment, the description thereof will be omitted. In addition, each modified example described in the first embodiment can also be applied to the fourth embodiment.

Although the embodiments of the present invention have been described above, the present invention is not limited to the embodiments, and various changes can be made without departing from the gist of the invention. In particular, the plurality of embodiments and modified examples described herein can be combined randomly with one another as necessary.

### Reference Signs List

10 Resin housing having an electronic component
20A, 20B, 20C, 50 Housing
20Ca, 50a Inner surface
20CH, 50H Speaker hole
30 Electronic component mounting film
31 Base film
31H Through-hole
32, 52 Circuit pattern layer
33, 53 Speaker (example of the electronic component)
34, 54 Mesh member
36 Reinforcing layer
36M Mesh member
36H Through-hole
40 Impact absorbing layer
51 Substrate
55 Electronic component mounting substrate
56 Adhesive
60 Smartwatch
65 Display panel
100 First mold
110 Pocket
120 Suction hole
130 Injection port
200 Second mold
210 Pin
250 Cavity
300 Molten resin
331 MEMS chip
332 IC chip
333 Vibration film
334 Ceramic substrate
335 Sound hole
336 Terminal electrode
337 Solder ball
338 Cover

## Claims

1. A resin housing having an electronic component, comprising:
a housing made of resin; and
an electronic component mounting film that includes a base film, a circuit pattern layer, an electronic component, and a reinforcing layer, the base film being disposed along an inner surface of the housing, the circuit pattern layer being formed on at least a surface opposite to a side of the housing of the base film, the electronic component being connected to the circuit pattern layer and mounted on a surface opposite to the side of the housing of the base film, the reinforcing layer being formed on the side of the housing of the base film facing the electronic component, the electronic component being integrated with the housing without the electronic component being buried in the housing.

2. The resin housing having the electronic component according to claim 1, wherein
the reinforcing layer is formed of a reinforcing plate bonded to the base film.

3. The resin housing having the electronic component according to claim 2, wherein
a material of the reinforcing plate is any one of a polyimide resin, a polycarbonate resin, a polyethylene terephthalate resin, and a metal.

4. The resin housing having the electronic component according to claim 1, wherein
the reinforcing layer is formed of a cured coating film of a UV-curable resin or a thermosetting resin.

5. The resin housing having the electronic component according to any one of claims 2 to 4, wherein
the reinforcing layer includes a mesh member inside the layer.

6. The resin housing having the electronic component according to claim 5, comprising
an opening penetrating a laminated body from the housing to the base film, wherein
the mesh member is present in the reinforcing layer so as to at least overlap with a through-hole constituting the opening in the reinforcing layer.

7. The resin housing having the electronic component according to any one of claims 1 to 6, wherein
a formation region of the reinforcing layer internally includes an entire mounting region of the electronic component.

8. The resin housing having the electronic component according to any one of claims 1 to 6, wherein
a formation region of the reinforcing layer is a part of a mounting region of the electronic component.

9. A method for manufacturing a resin housing having an electronic component, comprising:
preparing an electronic component mounting film that includes a base film, a circuit pattern layer formed on at least one surface of the base film, an electronic component being connected to the circuit pattern layer and mounted on one surface of the base film, and a reinforcing layer being formed on the other surface of the base film facing the electronic component;
setting the electronic component mounting film in a first mold such that a surface on which the electronic component is mounted of the electronic component mounting film faces the first mold and the electronic component fits in a pocket of the first mold;
clamping the first mold and a second mold to form a cavity between the first mold with the electronic component mounting film and the second mold; and
injecting a molten resin into the cavity to mold a housing, and integrating the electronic component mounting film along an inner surface of the housing in a state where the electronic component is not buried in the housing.

10. The method for manufacturing the resin housing having the electronic component according to claim 9, wherein
a formation region of the reinforcing layer includes an entire formation region of the pocket.
